# EUROPEAN PATENT APPLICATION

(11) **EP 4 687 257 A1**
(43) Date of publication of application: **04.02.2026**
(21) Application number: 25181606.2
(22) Date of filing: 09.06.2025
(51) Int. Cl.: H02J 7/00

(54) **BATTERY CELL BALANCING DEVICE AND METHOD, AND BATTERY MANAGEMENT SYSTEM**

(30) Priority: 31.07.2024 KR 20240102160
(71) Applicant: SAMSUNG SDI CO., LTD., Yongin-si, Gyeonggi-do 17084 (KR)
(72) Inventor: LEE, Yong Dai, Suwon-si 16678 (KR)
(74) Representative: Marks & Clerk LLP

(57) **Abstract**

The present disclosure relates to a battery cell balancing device and method, and a battery management system, and the technical problem to be solved is to provide a mechanism capable of increasing a service lifespan of the battery pack by allowing a balancing function to be maximally used in a range in which a cell voltage measurement error may be compensated for even when an abnormality has occurred in an internal circuit of the battery management system (BMS). To this end, the present disclosure provides a configuration of determining whether an abnormality occurs in an RC circuit based on a cell voltage of a battery cell measured through the RC circuit of the BMS, and controlling a switching time of a balancing switch to compensate for a cell voltage measurement error caused by the abnormality in the RC circuit.

## Description

### FIELD

The present disclosure relates to a device and method for controlling balancing of a battery cell, and a battery management system.

### BACKGROUND

A battery pack may include battery cells and peripheral circuits including charge/discharge circuits. The peripheral circuit is typically manufactured as a printed circuit board and then connected to the battery cell. When an external power source is connected to an external terminal of the battery pack, the battery cells are charged, and when a load is connected to the external terminal, the battery cells are discharged. The charge/discharge circuit controls the charge/discharge of the battery cells between the external terminal and the battery cells. Generally, a plurality of battery cells are connected in series and parallel depending on a consumption capacity of the load.

The above information disclosed in this background section is for enhancement of understanding of the background of the present disclosure, and therefore, it may contain information that does not constitute related (or prior) art.

### SUMMARY

At least some embodiments of the present disclosure are directed to providing a battery cell balancing device and method for increasing a service lifespan of the battery pack by allowing a balancing function to be maximally used in a range in which a cell voltage measurement error may be compensated for even when an abnormality has occurred in a circuit applied to a battery pack for balancing of battery cells and cell voltage detection, and a battery management system.

However, objects that the present invention intends to achieve are not limited to the above-described objects and other objects that are not described may be clearly understood by those skilled in the art from the following description.

A battery cell balancing device according to one or more embodiments of the present disclosure, which in one or more example embodiments may solve the above technical problem, includes: a balancing circuit including a balancing switch provided on a discharge path that is formed when balancing of a battery cell is performed; an RC circuit connected between the battery cell and the balancing circuit to measure a cell voltage of the battery cell; and a processor that is configured to measure the cell voltage of the battery cell through the RC circuit after the balancing of the battery cell is completed, and is configured to control a switching time of the balancing switch to compensate for a cell voltage measurement error caused by an abnormality in the RC circuit when it is determined that the abnormality has occurred in the RC circuit based on the measured cell voltage.

In some embodiments, the processor may be configured to measure the cell voltage through the RC circuit after a predefined delay time from a time point when the balancing switch is turned off when the cell voltage is measured after the balancing of the battery cell is completed.

In some embodiments, the delay time may be predefined based on a time constant of the RC circuit when no abnormality occurs in the RC circuit.

In some embodiments, the cell voltage measurement error may be defined as a difference between a first cell voltage measured before the balancing of the battery cell is performed and a second cell voltage measured after the delay time from a time point when the balancing of the battery cell is completed as the balancing switch is turned off.

In some embodiments, the RC circuit may include a resistor connected on a path through which a current is drawn from the battery cell, and a capacitor connected to the balancing circuit in parallel at a node to which the resistor and the balancing circuit are connected and charged by the current drawn from the battery cell. The first cell voltage may be a voltage in a steady state formed when the capacitor is charged by the current drawn from the battery cell.

In some embodiments, the processor may be configured to determine that the abnormality has occurred in the RC circuit when the cell voltage measurement error is greater than or equal to a predefined threshold value.

In some embodiments, the processor may be configured to turn on the balancing switch for a predefined balancing time when performing the balancing of the battery cell when no abnormality occurs in the RC circuit. The processor may be configured to shorten the balancing time when the cell voltage measurement error is compensated for.

In some embodiments, the processor may be configured to shorten the balancing time by advancing an off time point of the balancing switch by a predefined calibration time when the cell voltage measurement error is compensated for.

In some embodiments, when the operation of advancing the off time point of the balancing switch by the predefined calibration time is defined as an error compensation operation, the processor is configured to repeatedly perform the error compensation operation whenever the balancing of the battery cell is performed until the cell voltage measurement error is smaller than a predefined threshold value.

In some embodiments, the processor is configured to stop the balancing of the battery cell after a current time point when the shortened balancing time according to the repeatedly performed error compensation operation is smaller than or equal to the predefined calibration time, and the cell voltage measurement error remains above or equal to the predefined threshold value.

According to some aspects, there is provided a battery cell balancing method, and the method may comprise performing, by a processor, balancing of a battery cell through a balancing circuit, wherein the balancing circuit includes a balancing switch provided on a discharge path that is formed when performing the balancing of the battery cell; measuring, by the processor, a cell voltage of the battery cell through an RC circuit after the balancing of the battery cell is completed, wherein the RC circuit is connected between the battery cell and the balancing circuit to measure the cell voltage of the battery cell; determining, by the processor, whether an abnormality has occurred in the RC circuit based on the measured cell voltage; and controlling, by the processor, a switching time of the balancing switch to compensate for a cell voltage measurement error caused by the abnormality in the RC circuit when it is determined that the abnormality has occurred in the RC circuit.

In some embodiments, in the measuring, the processor may measure the cell voltage through the RC circuit after a predefined delay time from a time point when the balancing switch is turned off.

In some embodiments, the RC circuit may include a resistor connected on a path through which a current is drawn from the battery cell, and a capacitor connected to the balancing circuit in parallel at a node to which the resistor and the balancing circuit are connected and charged by the current drawn from the battery cell. The battery cell balancing method may further comprise measuring, by the processor, a first cell voltage of the battery cell before the performing. The first cell voltage may be a voltage in a steady state formed when the capacitor is charged by the current drawn from the battery cell when the balancing switch is turned off.

In some embodiments, the cell voltage measurement error may be defined as a difference between the first cell voltage and a second cell voltage measured after the delay time from a time point when the balancing of the battery cell is completed as the balancing switch is turned off.

In some embodiments, in the determining, the processor may determine that the abnormality has occurred in the RC circuit when the cell voltage measurement error is greater than or equal to a predefined threshold value.

In some embodiments, the processor may be configured to turn on the balancing switch for a predefined balancing time when performing the balancing of the battery cell when no abnormality occurs in the RC circuit. **In** some embodiments, in the compensating, the processor may be configured to shorten the predefined balancing time.

In some embodiments, in the compensating, the processor may be configured to shorten the predefined balancing time by advancing an off time point of the balancing switch by a predefined calibration time.

In some embodiments, when the operation of advancing the off time point of the balancing switch by the predefined calibration time is defined as an error compensation operation, in the compensating, the processor may be configured to repeatedly perform the error compensation operation whenever the balancing of the battery cell is performed until the cell voltage measurement error is smaller than a predefined threshold value.

In some embodiments, the method may further comprise stopping, by the processor, the balancing of the battery cell after a current time point when the shortened balancing time according to the repeatedly performed error compensation operation is smaller than or equal to the predefined calibration time and the cell voltage measurement error remains above or equal to the predefined threshold value.

According to some aspects, there is provided a battery management system which may comprise a balancing circuit including a balancing switch provided on a discharge path that is formed when balancing of a battery cell is performed; an RC circuit connected between the battery cell and the balancing circuit to measure a cell voltage of the battery cell; an analog front end integrated circuit (AFE IC) configured to measure the cell voltage of the battery cell through the RC circuit after the balancing of the battery cell is completed; and a micro controller unit (MCU) that is configured to receive the cell voltage measured by the AFE IC and configured to determine whether an abnormality has occurred in the RC circuit, and configured to transmit a control signal for controlling a switching time of the balancing switch to the AFE IC when it is determined that the abnormality has occurred in the RC circuit, wherein the AFE IC is configured to control the switching time of the balancing switch based on the control signal received from the MCU to compensate for a cell voltage measurement error caused by the abnormality in the RC circuit.

At least some of the above and other features of the invention are set out in the claims.

### BRIEF DESCRIPTION OF THE DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings, in which:
FIG. 1 is a circuit diagram of a battery cell balancing device according to an embodiment of the present disclosure;
FIGS. 2 to 4 illustrate an example in which battery cell balancing is performed in the battery cell balancing device according to an embodiment of the present disclosure;
FIG. 5 illustrates an example of a cell voltage measurement error caused by an abnormality in an RC circuit in the battery cell balancing device according to an embodiment of the present disclosure;
FIGS. 6 and 7 illustrate an example of an error compensation operation of the battery cell balancing device according to one embodiment of the present disclosure;
FIG. 8 is a circuit diagram of a battery management system according to an embodiment of the present disclosure; and
FIG. 9 is a flow chart of a battery cell balancing method according to an embodiment of the present disclosure.

### DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and being consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and possible features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the drawings, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, the applicant reserves the right to amend this specification, including the claims, to expressly recite any sub-range subsumed within the ranges expressly recited herein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to each other.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

Regarding prior art systems, there is a capacity deviation in the battery cells constituting the battery pack due to various reasons arising from the manufacturing process of the battery cells, and as the battery cells are repeatedly charged and discharged, a deviation between the cell voltages of the battery cells occurs. Accordingly, some of the battery cells may be overcharged during charge, or some of the battery cells may be overdischarged during discharge. Thus, as some of the battery cells are overcharged or overdischarged, not only does the capacity of the battery pack decrease, but also the deterioration of the battery pack rapidly progresses and a lifespan thereof is shortened.

Turning now to at least some of the embodiments of the invention, in order to eliminate or mitigate capacity and voltage deviations between the battery cells, a cell balancing function is applied to a battery management system (BMS) of the battery pack, and the battery management system performs discharge on the battery cells with relatively high capacity and voltage so that the capacity and voltage of each battery cell are distributed in a set range. Other advantages and problems solved by the embodiments illustrated and described herein will be readily apparent to those of skill in the art.

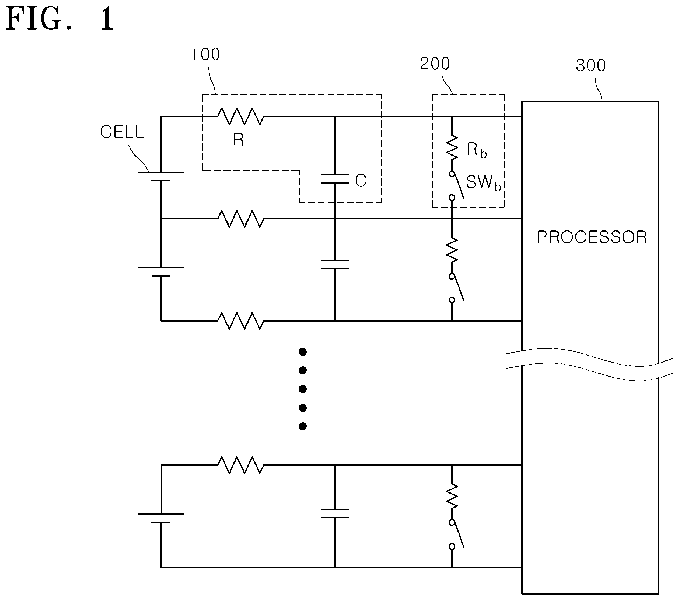

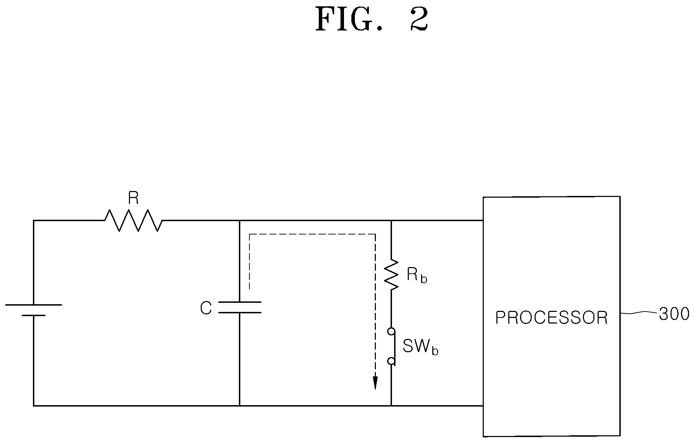

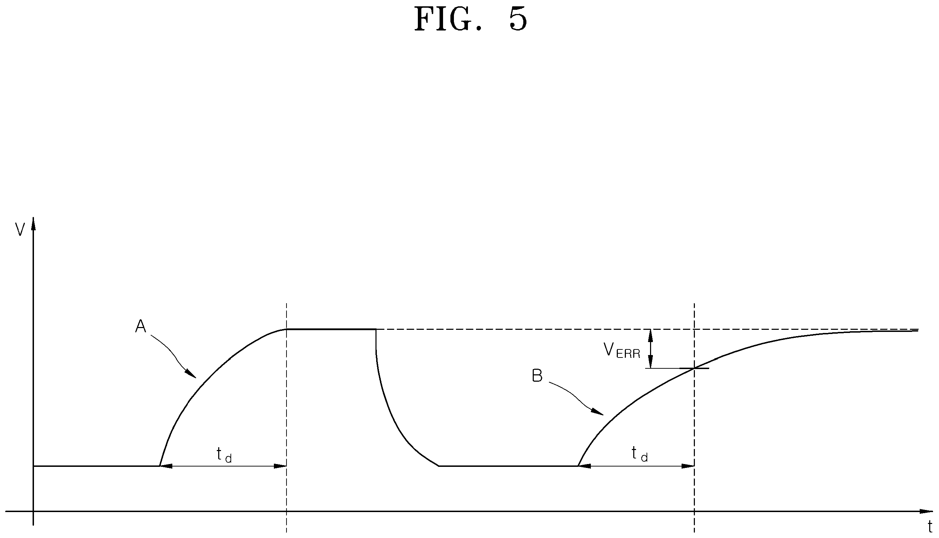

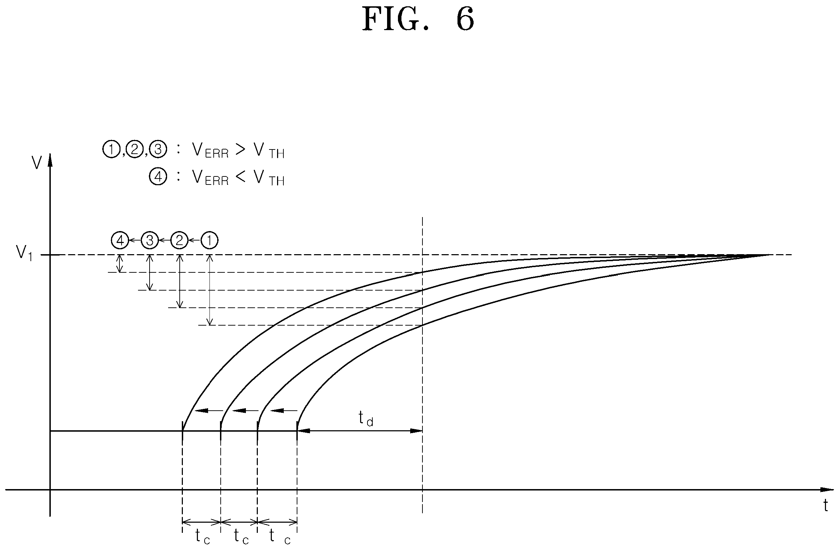

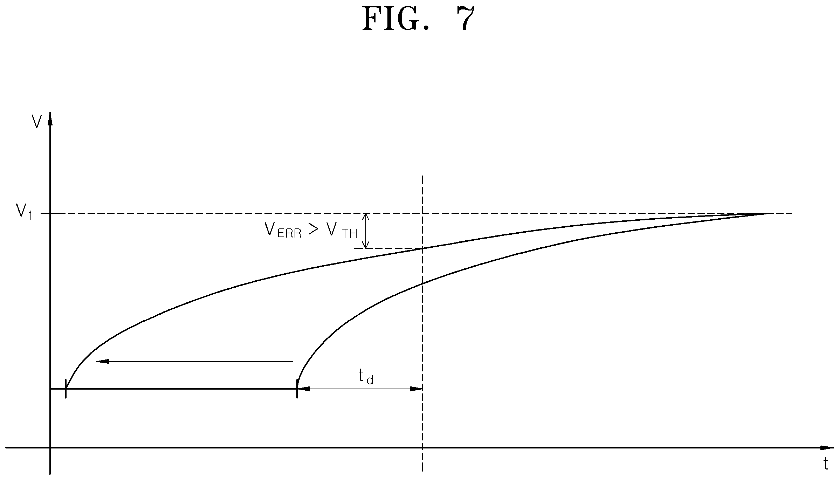

FIG. 1 is a circuit diagram of a battery cell balancing device according to an embodiment of the present disclosure, FIGS. 2 to 4 are example diagrams illustrating a process in which battery cell balancing is performed in the battery cell balancing device according to an embodiment of the present disclosure, FIG. 5 is an example diagram illustrating a cell voltage measurement error caused by an abnormality in an RC circuit in the battery cell balancing device according to an embodiment of the present disclosure, and FIGS. 6 and 7 are example diagrams illustrating an error compensation operation of the battery cell balancing device according to an embodiment of the present disclosure.

First, referring to FIG. 1, the battery cell balancing device according to the embodiment may include an RC circuit 100, a balancing circuit 200, and a processor 300. As shown in FIG. 1, the RC circuit 100 and the balancing circuit 200 may be provided in numbers (quantities) corresponding to the number of battery cells CELL interconnected in series, and a balancing control operation of the processor 300 described herein may be performed for each battery cell. Since specific operations of balancing control performed for each battery cell are the same, the description of the embodiment focuses on a process of controlling the balancing for a specific battery cell.

The RC circuit 100 may correspond to a filter circuit connected between the battery cell and the balancing circuit 200 described herein to stably measure a cell voltage of the battery cell. The RC circuit 100 may include a resistor R connected on a path through which a current is drawn from the battery cell when the balancing of the battery cell is performed (that is, an on state of a balancing switch SW_{b} described herein), and a capacitor C connected to the balancing circuit 200 in parallel at a node to which the resistor R and the balancing circuit 200 are connected and charged by the current drawn from the battery cell. The processor 300 described herein may operate to measure a voltage across the capacitor C of the RC circuit 100 as the cell voltage of the battery cell. A resistance value of the resistor R and capacitance of the capacitor C may be designed to be specific values based on the specifications of the battery pack and the experimental results of the designer to prevent distortion of cell voltage measurement due to the cell balancing operation of the processor 300 described herein.

The balancing circuit 200 may include a balancing resistor R_{b} and a balancing switch SW_{b} provided on a discharge path formed when the balancing of the battery cell is performed. The on/off operation of the balancing switch SW_{b} may be controlled by the processor 300, and the balancing switch SW_{b} may be implemented with a relay or field-effect transistor (FET). FIGS. 1 to 3 illustrate a structure in which the balancing circuit 200 is separated from the processor 300 in a circuit, but an embodiment in which the balancing circuit 200 is included (integrated) in the processor 300 may also be provided.

The processor 300 is the entity which detects an abnormality in the above-described RC circuit 100 and controls the balancing of the battery cell according to the detection result, and may be implemented as a central processing unit (CPU) or system on chip (SoC), may control a plurality of hardware or software components connected to the processor 300 by driving an operating system or application, and may perform various types of data processing and calculations. Specifically, in the illustrated embodiment, the processor 300 may correspond to an analog front end integrated circuit (AFE IC) of a battery management system (BMS) which monitors the states of the battery, such as a voltage, a current, a temperature, and a state of charge (SOC) of the battery cell, and controls the balancing of the battery cell according to the monitoring result.

A balancing cycle performed on the battery cell by the processor 300 will be described based on the capacitor C as follows. For reference, FIGS. 2 to 4 assume that no abnormality occurs in the RC circuit 100.

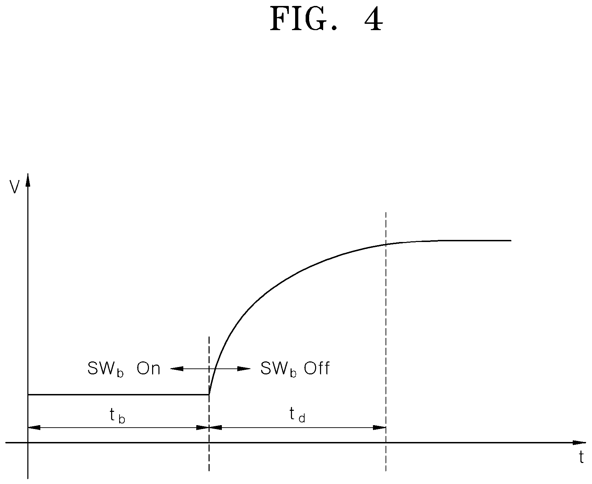

Referring to FIGS. 2 and 4, when it is determined that balancing of the battery cell is needed, the processor 300 turns on the balancing switch SW_{b}, and accordingly, since the current is drawn from the capacitor C and flows to the balancing circuit 200, the capacitor C is discharged. When a predefined balancing time t_{b} has elapsed from a time point when the balancing switch SW_{b} is turned on, the processor 300 turns off the balancing switch SW_{b} to complete the balancing. The above operation is indicated as operation ①.

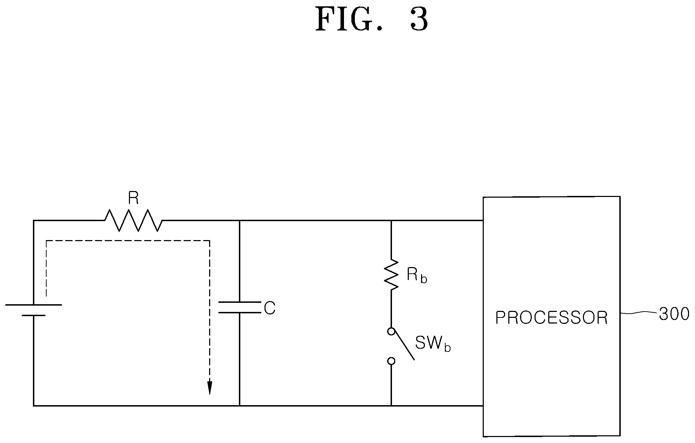

Referring to FIGS. 3 and 4, when the balancing switch SW_{b} is turned off, the capacitor C is charged by the current drawn from the battery cell. When a time t_{d} corresponding to a time constant (τ = RC) of the RC circuit 100 (or rather 5τ, and for convenience, 5τ is expressed as the time constant in the embodiment) elapses from a time point when the balancing switch SW_{b} is turned off, the RC circuit 100 enters a steady state, and the processor 300 operates to measure the voltage of the capacitor C in the steady state as the cell voltage of the battery cell. The above operation is indicated as operation ②.

In operation ②, the processor 300 is configured to measure the cell voltage through the RC circuit 100 after a predefined delay time t_{d} from the time point when the balancing switch SW_{b} is turned off. The above-described delay time t_{d} may be a time corresponding to the time constant of the RC circuit 100 when no abnormality occurs in the RC circuit 100. That is, the processor 300 may measure the voltage of the capacitor C in a steady state of the RC circuit 100 formed when the capacitor C is charged by the current drawn from the battery cell as the balancing switch SW_{b} is turned off, as a battery cell voltage.

Meanwhile, when a defect occurs in a connection between the resistor R and the capacitor C or the resistance value or capacitance increases due to damage to the resistor R or capacitor C (in the embodiment, this corresponds to a case in which the abnormality occurs in the RC circuit 100), the time constant of the RC circuit 100 increases, and accordingly, the time required for the steady state to be formed in the RC circuit 100 from the time point when the balancing switch SW_{b} is turned off also increases (see 'B' in FIG. 5). As mentioned above, the processor 300 operates to measure the battery cell voltage at a time point after the delay time t_{d} (that is, the time corresponding to the time constant of the RC circuit 100 in the state in which no abnormality occurs in the RC circuit 100) has elapsed from the time point when the balancing switch SW_{b} is turned off, and accordingly, as shown in FIG. 5, an error V_{ERR} occurs between the cell voltage measured by the processor 300 when no abnormality occurs in the RC circuit 100 (see 'A' in FIG. 5) based on the time point corresponding to the above-described delay time t_{d} and the cell voltage measured by the processor 300 when an abnormality occurs in the RC circuit 100 (see 'B' in FIG. 5). When the battery pack and peripheral circuits are controlled according to the cell voltage in which this error is reflected, additional battery pack failure may occur.

At least some embodiments propose a battery cell balancing mechanism for increasing a service lifespan of the battery pack by detecting the above cell voltage measurement error (that is, 'V_{ERR}' in FIG. 5) and allowing the balancing function to be maximally used in a range in which the cell voltage measurement error may be compensated for.

Specifically, the processor 300 may measure the cell voltage of the battery cell through the RC circuit 100 after the balancing of the battery cell is completed, and when it is determined that an abnormality has occurred in the RC circuit 100 based on the measured cell voltage, may control a switching time of the balancing switch SW_{b} to compensate for the cell voltage measurement error caused by the abnormality in the RC circuit 100.

The cell voltage measurement error is defined as a difference between a first cell voltage measured before the balancing of the battery cell is performed and a second cell voltage measured after the above-described delay time from the time point when the balancing of the battery cell is completed as the balancing switch SW_{b} is turned off. The first cell voltage measured before the balancing of the battery cell is performed corresponds to the voltage of the capacitor C in a steady state of RC circuit 100 which is a state in which the balancing switch SW_{b} is turned off, and functions as a reference value compared to the second cell voltage to determine whether the RC circuit 100 is abnormal.

Since a case in which the cell voltage measurement error defined as above is greater than or equal to a predefined threshold value corresponds to a case in which the time constant has increased due to an abnormality in the RC circuit 100 as shown in FIG. 5, the processor 300 may then determine that an abnormality has occurred in the RC circuit 100 and compensate for the cell voltage measurement error. The above-described threshold value is a value compared to the difference between the first and second cell voltages to determine whether an abnormality has occurred in the RC circuit 100, and may be designed to be a specific value based on the experimental results of the designer.

As described herein, the processor 300 is configured to turn on the balancing switch SW_{b} for a predefined balancing time when performing the balancing of the battery cell when no abnormality occurs in the RC circuit 100. On the other hand, when an abnormality has occurred in the RC circuit 100, the processor 300 may compensate for the cell voltage measurement error by shortening the balancing time.

Specifically, the processor 300 may shorten the balancing time by advancing an off time point of the balancing switch SW_{b} by a predefined calibration time t_{c} when the cell voltage measurement error is compensated for.

Referring to FIG. 6, the cell voltage is shifted to the left as the off time point of the balancing switch SW_{b} is advanced. This means that the second cell voltage measured at a time point after a delay time has elapsed from the time point when the balancing switch SW_{b} is turned off approaches a first cell voltage V1 corresponding to the voltage of the capacitor C in a steady state of the RC circuit 100, and thus a cell voltage measurement error V_{ERR} decreases.

When the operation of advancing the off time point of the balancing switch SW_{b} by the calibration time t_{c} is defined as an error compensation operation, the processor 300 may repeatedly perform the error compensation operation whenever the balancing of the battery cells is performed until the cell voltage measurement error V_{ERR} is smaller than a threshold value V_{TH}. FIG. 6 illustrates an example in which the cell voltage measurement error V_{ERR} is smaller than the threshold value V_{TH} when the error compensation operation is performed three times. When the cell voltage measurement error V_{ERR} is smaller the threshold value V_{TH}, the processor 300 may operate to control the balancing of the corresponding battery cell according to the finally shortened balancing time when performing the balancing after the corresponding time point.

As shown in FIG. 7, when the error compensation operation is repeatedly performed but the cell voltage measurement error V_{ERR} remains above or equal to the threshold value V_{TH}, and the shortened balancing time (that is, the available time for performing balancing) is smaller than or equal to the calibration time and thus additionally shortening the balancing time is impossible, the processor 300 may stop the balancing of the battery cell after the current time point and notify this situation to a user through an interface device (not shown) for interfacing with the user.

A process of determining an abnormality in the RC circuit 100 based on the cell voltage of the battery cell measured through the RC circuit 100 and performing the error compensation operation according to the determination result may be periodically performed according to a predefined cycle. Accordingly, a phenomenon in which the cell voltage measurement error continuously increases as the balancing of the battery cell continues for a long time may be prevented.

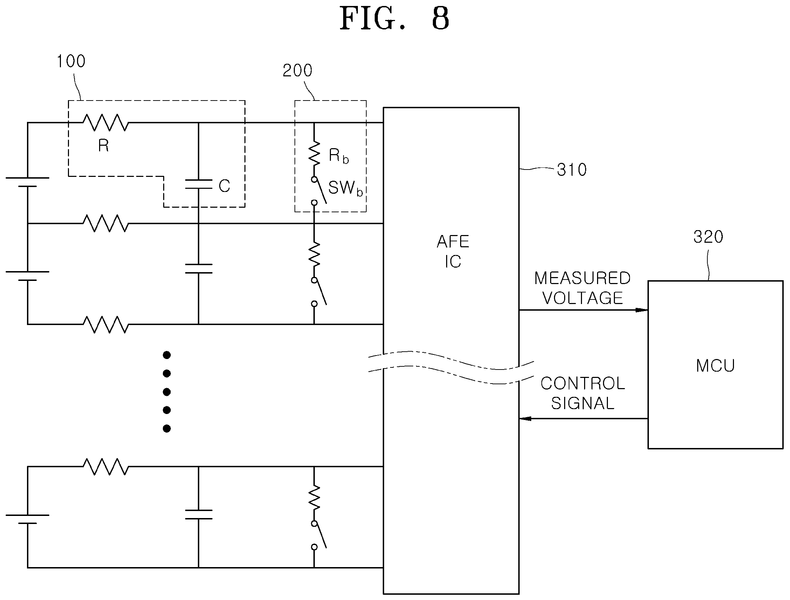

In the above, the entity which determines the abnormality in the RC circuit 100 based on the cell voltage of the battery cell measured through the RC circuit 100 and performs error compensation operation according to the determination result was described as corresponding to the processor 300 (that is, the AFE IC), and as shown in FIG. 8, this operation of the processor 300 may also be functionally separated and performed by an AFE IC 310 and a micro controller unit (MCU) 320 of the BMS.

Specifically, the AFE IC 310 may measure the first cell voltage of the battery cell through the RC circuit 100 and transmit the first cell voltage to the MCU 320 before the balancing of the battery cell is performed, and perform the cell balancing of the battery cell under control of the MCU 320. After the balancing of the battery cell is completed, the AFE IC 310 may measure the second cell voltage of the battery cell through the RC circuit 100 and transmit the second cell voltage to the MCU 320.

The MCU 320 determines whether an abnormality has occurred in the RC circuit 100 based on the first and second cell voltages received from the AFE IC 310, and may transmit a control signal for controlling the switching time of the balancing switch SW_{b} to the AFE IC 310 when it is determined that an abnormality has occurred in the RC circuit 100.

Thereafter, the AFE IC 310 may control the switching time of the balancing switch SW_{b} based on the control signal received from the MCU 320 to compensate for the cell voltage measurement error caused by the abnormality in the RC circuit 100.

In the above embodiment, the RC circuit 100, the balancing circuit 200, the AFE IC 310, and the MCU 320 constitute the BMS.

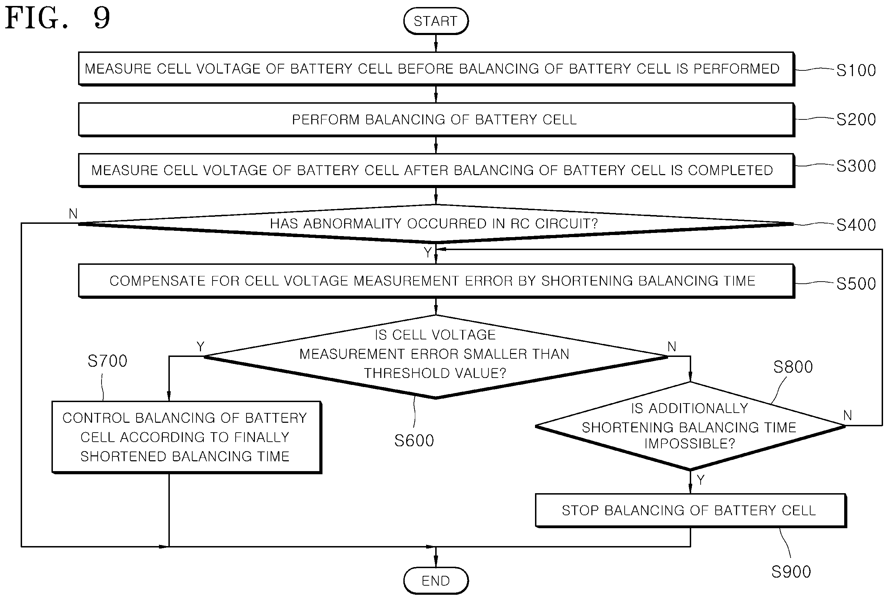

FIG. 9 is a flow chart of a battery cell balancing method according to one embodiment of the present disclosure. The battery cell balancing method of the embodiment will be described with reference to FIG. 9, specific description of configurations overlapping the above-described content will be omitted, and description will focus on a time-series configuration.

First, a processor 300 measures a cell voltage (that is, a first cell voltage) of a battery cell through a RC circuit 100 before balancing of the battery cell is performed (S100). The cell voltage measured in operation S100 may correspond to a voltage in a steady state formed when a capacitor C is charged by a current drawn from the battery cell when a balancing switch SW_{b} is turned off

Subsequently, the processor 300 performs the balancing of the battery cell through a balancing circuit 200 (S200). Operation S200 corresponds to an operation before determining whether there is an abnormality in the RC circuit 100, and accordingly, in operation S200, the processor 300 performs the balancing of the battery cell by turning on the balancing switch SW_{b} for a predefined balancing time.

Subsequently, the processor 300 measures a cell voltage (that is, a second cell voltage) of the battery cell through the RC circuit 100 after the balancing of the battery cell in operation S200 is completed (S300). The cell voltage measured in operation S300 may correspond to a voltage measured through the RC circuit 100 after a predefined delay time from a time point when the balancing switch SW_{b} is turned off.

Subsequently, the processor 300 determines whether an abnormality has occurred in the RC circuit 100 based on the cell voltages (that is, the first and second cell voltages) respectively measured in operations S100 and S300 (S400). In operation S400, the processor 300 determines that an abnormality has occurred in the RC circuit 100 when a difference between the first and second cell voltages (that is, a cell voltage measurement error) is greater than or equal to a predefined threshold value.

When it is determined that an abnormality has occurred in the RC circuit 100 in operation S400, the processor 300 controls the switching time of the balancing switch SW_{b} when performing next balancing to compensate for the cell voltage measurement error caused by the abnormality in the RC circuit 100 (S500).

In operation S500, the processor 300 compensates for the cell voltage measurement error by shortening the predefined balancing time (that is, the balancing time applied to operation S200). That is, the balancing time applied to operation S500 has a shorter length of time than the balancing time applied to operation S200. In this case, the processor 300 shortens the balancing time by advancing an off time point of the balancing switch SW_{b} by a predefined calibration time.

When the operation of advancing the off time point of the balancing switch SW_{b} by the calibration time is defined as an error compensation operation, in operation S500, the processor 300 repeatedly performs the error compensation operation whenever the balancing of the battery cell is performed until the cell voltage measurement error is smaller than the predefined threshold value in a range in which additionally shortening the balancing time is possible.

When it is determined that the cell voltage measurement error is smaller than the threshold value through operation S500 (S600), the processor 300 controls the balancing of the corresponding battery cell according to a finally shortened balancing time when performing the balancing after the corresponding time point (S700).

When the cell voltage measurement error remains above or equal to the threshold value even when the error compensation operation is repeatedly performed through operation S500 (S600), and when it is determined that the shortened balancing time so far is less than or equal to the calibration time and thus additionally shortening the balancing time is impossible (S800), the processor 300 may stop the balancing of the corresponding battery cell after the current time point and notify this situation to a user through an interface device for interfacing with the user (S900).

As described herein, according to the present disclosure, and for at least some embodiments, when it is determined that an abnormality has occurred in the RC circuit based on a battery cell voltage, as the switching time of the balancing switch is controlled to compensate for the cell voltage measurement error caused by the abnormality in the RC circuit, a service lifespan of the battery pack can be increased by preventing secondary mismeasurement of the cell voltage caused by the abnormality in the RC circuit, and allowing a balancing function to be maximally used in a range in which the cell voltage measurement error can be compensated for.

The embodiments described herein may be implemented, for example, as a method or process, a device, a software program, a data stream, or a signal. Although discussed in the context of a single type of implementation (for example, discussed as a method), features discussed herein may also be implemented in other forms (for example, a device or a program). The device may be implemented by suitable hardware, software (e.g., instructions encoded on at least one non-transitory computer-readable storage medium), firmware, and the like. The method may be implemented on a device, such as a processor that generally refers to a processing device including a computer, a microprocessor, an integrated circuit, a programmable logic device, etc. The processor includes a communication device such as a computer, a cell phone, a personal digital assistant (PDA), and other devices that facilitate communication of information between the device and end-users.

According to the present disclosure, and for at least some embodiments, when it is determined that an abnormality has occurred in an RC circuit based on a battery cell voltage, a switching time of a balancing switch is controlled to compensate for a cell voltage measurement error caused by the abnormality in the RC circuit, and a service lifespan of a battery pack can be increased by preventing secondary mismeasurement of the cell voltage caused by the abnormality in the RC circuit, and allowing a balancing function to be maximally used in a range in which the cell voltage measurement error can be compensated for.

However, effects that can be achieved through the present invention are not limited to the above-described effects and other effects that are not described may be clearly understood by those skilled in the art from the detailed descriptions.

Although the present disclosure has been described with reference to embodiments and drawings illustrating aspects thereof, the present disclosure is not limited thereto. Various modifications and variations can be made by a person skilled in the art to which the present disclosure belongs within the scope of the present disclosure and the claims and their equivalents, below.

Embodiments are set out in the following clauses:
Clause 1. A battery cell balancing device comprising:
   a balancing circuit including a balancing switch provided on a discharge path that is formed when balancing of a battery cell is performed;
   an RC circuit connected between the battery cell and the balancing circuit to measure a cell voltage of the battery cell; and
   a processor that measures the cell voltage of the battery cell through the RC circuit after the balancing of the battery cell is completed, and controls a switching time of the balancing switch to compensate for a cell voltage measurement error caused by an abnormality in the RC circuit when it is determined that the abnormality has occurred in the RC circuit based on the measured cell voltage.
Clause 2. The battery cell balancing device of clause 1, wherein the processor is configured to measure the cell voltage through the RC circuit after a predefined delay time from a time point when the balancing switch is turned off when the cell voltage is measured after the balancing of the battery cell is completed.
Clause 3. The battery cell balancing device of clause 2, wherein the delay time is predefined based on a time constant of the RC circuit when no abnormality occurs in the RC circuit.
Clause 4. The battery cell balancing device of clause 2 or clause 3, wherein the cell voltage measurement error is defined as a difference between a first cell voltage measured before the balancing of the battery cell is performed and a second cell voltage measured after the delay time from a time point when the balancing of the battery cell is completed as the balancing switch is turned off.
Clause 5. The battery cell balancing device of clause 4, wherein:
   the RC circuit includes a resistor connected on a path through which a current is drawn from the battery cell, and a capacitor connected to the balancing circuit in parallel at a node to which the resistor and the balancing circuit are connected and charged by the current drawn from the battery cell; and
   the first cell voltage is a voltage in a steady state formed when the capacitor is charged by the current drawn from the battery cell.
Clause 6. The battery cell balancing device of clause 4 or clause 5, wherein the processor determines that the abnormality has occurred in the RC circuit when the cell voltage measurement error is greater than or equal to a predefined threshold value.
Clause 7. The battery cell balancing device of any of clauses 1 to 6, wherein the processor is configured to turn on the balancing switch for a predefined balancing time when performing the balancing of the battery cell when no abnormality occurs in the RC circuit, and shorten the balancing time when the cell voltage measurement error is compensated for.
Clause 8. The battery cell balancing device of clause 7, wherein the processor shortens the balancing time by advancing an off time point of the balancing switch by a predefined calibration time when the cell voltage measurement error is compensated for.
Clause 9. The battery cell balancing device of clause 8, wherein, when the operation of advancing the off time point of the balancing switch by the predefined calibration time is defined as an error compensation operation, the processor repeatedly performs the error compensation operation whenever the balancing of the battery cell is performed until the cell voltage measurement error is smaller than a predefined threshold value.
Clause 10. The battery cell balancing device of clause 9, wherein the processor stops the balancing of the battery cell after a current time point when the shortened balancing time according to the repeatedly performed error compensation operation is smaller than or equal to the predefined calibration time, and the cell voltage measurement error remains above or equal to the predefined threshold value.
Clause 11. A battery cell balancing method comprising:
   performing, by a processor, balancing of a battery cell through a balancing circuit, wherein the balancing circuit includes a balancing switch provided on a discharge path that is formed when performing the balancing of the battery cell;
   measuring, by the processor, a cell voltage of the battery cell through an RC circuit after the balancing of the battery cell is completed, wherein the RC circuit is connected between the battery cell and the balancing circuit to measure the cell voltage of the battery cell;
   determining, by the processor, whether an abnormality has occurred in the RC circuit based on the measured cell voltage; and
   controlling, by the processor, a switching time of the balancing switch to compensate for a cell voltage measurement error caused by the abnormality in the RC circuit when it is determined that the abnormality has occurred in the RC circuit.
Clause 12. The battery cell balancing method of clause 11, wherein, in the measuring, the processor measures the cell voltage through the RC circuit after a predefined delay time from a time point when the balancing switch is turned off.
Clause 13. The battery cell balancing method of clause 12, wherein:
   the RC circuit includes a resistor connected on a path through which a current is drawn from the battery cell, and a capacitor connected to the balancing circuit in parallel at a node to which the resistor and the balancing circuit are connected and charged by the current drawn from the battery cell; and
   the battery cell balancing method further comprises measuring, by the processor, a first cell voltage of the battery cell before the performing, wherein the first cell voltage is a voltage in a steady state formed when the capacitor is charged by the current drawn from the battery cell when the balancing switch is turned off.
Clause 14. The battery cell balancing method of clause 13, wherein the cell voltage measurement error is defined as a difference between the first cell voltage and a second cell voltage measured after the delay time from a time point when the balancing of the battery cell is completed as the balancing switch is turned off.
Clause 15. The battery cell balancing method of clause 14, wherein, in the determining, the processor determines that the abnormality has occurred in the RC circuit when the cell voltage measurement error is greater than or equal to a predefined threshold value.
Clause 16. The battery cell balancing method of any of clauses 11 to 15, wherein:
   the processor is configured to turn on the balancing switch for a predefined balancing time when performing the balancing of the battery cell when no abnormality occurs in the RC circuit; and
   in the compensating, the processor shortens the predefined balancing time.
Clause 17. The battery cell balancing method of clause 16, wherein, in the compensating, the processor shortens the predefined balancing time by advancing an off time point of the balancing switch by a predefined calibration time.
Clause 18. The battery cell balancing method of clause 17, wherein when the operation of advancing the off time point of the balancing switch by the predefined calibration time is defined as an error compensation operation, in the compensating, the processor repeatedly performs the error compensation operation whenever the balancing of the battery cell is performed until the cell voltage measurement error is smaller than a predefined threshold value.
Clause 19. The battery cell balancing method of clause 18, further comprising, stopping, by the processor, the balancing of the battery cell after a current time point when the shortened balancing time according to the repeatedly performed error compensation operation is smaller than or equal to the predefined calibration time and the cell voltage measurement error remains above or equal to the predefined threshold value.
Clause 20. A battery management system comprising:
   a balancing circuit including a balancing switch provided on a discharge path that is formed when balancing of a battery cell is performed;
   an RC circuit connected between the battery cell and the balancing circuit to measure a cell voltage of the battery cell;
   an analog front end integrated circuit (AFE IC) configured to measure the cell voltage of the battery cell through the RC circuit after the balancing of the battery cell is completed; and
   a micro controller unit (MCU) that receives the cell voltage measured by the AFE IC and determines whether an abnormality has occurred in the RC circuit, and transmits a control signal for controlling a switching time of the balancing switch to the AFE IC when it is determined that the abnormality has occurred in the RC circuit,
   wherein the AFE IC controls the switching time of the balancing switch based on the control signal received from the MCU to compensate for a cell voltage measurement error caused by the abnormality in the RC circuit.

## Claims

1. A battery cell balancing device comprising:
a balancing circuit including a balancing switch provided on a discharge path that is formed when balancing of a battery cell is performed;
an RC circuit connected between the battery cell and the balancing circuit to measure a cell voltage of the battery cell; and
a processor that is configured to measure the cell voltage of the battery cell through the RC circuit after the balancing of the battery cell is completed, and is configured to control a switching time of the balancing switch to compensate for a cell voltage measurement error caused by an abnormality in the RC circuit when it is determined that the abnormality has occurred in the RC circuit based on the measured cell voltage.

2. The battery cell balancing device of claim 1, wherein the processor is configured to measure the cell voltage through the RC circuit after a predefined delay time from a time point when the balancing switch is turned off when the cell voltage is measured after the balancing of the battery cell is completed.

3. The battery cell balancing device of claim 2, wherein the delay time is predefined based on a time constant of the RC circuit when no abnormality occurs in the RC circuit.

4. The battery cell balancing device of claim 2 or claim 3, wherein the cell voltage measurement error is defined as a difference between a first cell voltage measured before the balancing of the battery cell is performed and a second cell voltage measured after the delay time from a time point when the balancing of the battery cell is completed as the balancing switch is turned off,
wherein the processor is configured to determine that the abnormality has occurred in the RC circuit when the cell voltage measurement error is greater than or equal to a predefined threshold value.

5. The battery cell balancing device of claim 4, wherein:
the RC circuit includes a resistor connected on a path through which a current is drawn from the battery cell, and a capacitor connected to the balancing circuit in parallel at a node to which the resistor and the balancing circuit are connected and charged by the current drawn from the battery cell; and
the first cell voltage is a voltage in a steady state formed when the capacitor is charged by the current drawn from the battery cell.

6. The battery cell balancing device of any of claims 1 to 5, wherein the processor is configured to turn on the balancing switch for a predefined balancing time when performing the balancing of the battery cell when no abnormality occurs in the RC circuit, and configured to shorten the balancing time when the cell voltage measurement error is compensated for.

7. The battery cell balancing device of claim 6, wherein the processor is configured to shorten the balancing time by advancing an off time point of the balancing switch by a predefined calibration time when the cell voltage measurement error is compensated for.

8. The battery cell balancing device of claim 7, wherein, when the operation of advancing the off time point of the balancing switch by the predefined calibration time is defined as an error compensation operation, the processor is configured to repeatedly perform the error compensation operation whenever the balancing of the battery cell is performed until the cell voltage measurement error is smaller than a predefined threshold value.

9. The battery cell balancing device of claim 8, wherein the processor is configured to stop the balancing of the battery cell after a current time point when the shortened balancing time according to the repeatedly performed error compensation operation is smaller than or equal to the predefined calibration time, and the cell voltage measurement error remains above or equal to the predefined threshold value.

10. A battery cell balancing method, the method comprising:
performing, by a processor, balancing of a battery cell through a balancing circuit, wherein the balancing circuit includes a balancing switch provided on a discharge path that is formed when performing the balancing of the battery cell;
measuring, by the processor, a cell voltage of the battery cell through an RC circuit after the balancing of the battery cell is completed, wherein the RC circuit is connected between the battery cell and the balancing circuit to measure the cell voltage of the battery cell;
determining, by the processor, whether an abnormality has occurred in the RC circuit based on the measured cell voltage; and
controlling, by the processor, a switching time of the balancing switch to compensate for a cell voltage measurement error caused by the abnormality in the RC circuit when it is determined that the abnormality has occurred in the RC circuit.

11. The battery cell balancing method of claim 10, wherein, in the measuring, the processor measures the cell voltage through the RC circuit after a predefined delay time from a time point when the balancing switch is turned off, and
wherein:
the RC circuit includes a resistor connected on a path through which a current is drawn from the battery cell, and a capacitor connected to the balancing circuit in parallel at a node to which the resistor and the balancing circuit are connected and charged by the current drawn from the battery cell; and
the battery cell balancing method further comprises measuring, by the processor, a first cell voltage of the battery cell before the performing, wherein the first cell voltage is a voltage in a steady state formed when the capacitor is charged by the current drawn from the battery cell when the balancing switch is turned off.

12. The battery cell balancing method of claim 11, wherein the cell voltage measurement error is defined as a difference between the first cell voltage and a second cell voltage measured after the delay time from a time point when the balancing of the battery cell is completed as the balancing switch is turned off, and
wherein, in the determining, the processor determines that the abnormality has occurred in the RC circuit when the cell voltage measurement error is greater than or equal to a predefined threshold value.

13. The battery cell balancing method of any of claims 10 to 12, wherein:
the processor is configured to turn on the balancing switch for a predefined balancing time when performing the balancing of the battery cell when no abnormality occurs in the RC circuit; and
in the compensating, the processor is configured to shorten the predefined balancing time,
wherein, in the compensating, the processor shortens the predefined balancing time by advancing an off time point of the balancing switch by a predefined calibration time.

14. The battery cell balancing method of claim 13, wherein when the operation of advancing the off time point of the balancing switch by the predefined calibration time is defined as an error compensation operation, in the compensating, the processor may be configured to repeatedly perform the error compensation operation whenever the balancing of the battery cell is performed until the cell voltage measurement error is smaller than a predefined threshold value,
wherein the method further comprises, stopping, by the processor, the balancing of the battery cell after a current time point when the shortened balancing time according to the repeatedly performed error compensation operation is smaller than or equal to the predefined calibration time and the cell voltage measurement error remains above or equal to the predefined threshold value.

15. A battery management system comprising:
a balancing circuit including a balancing switch provided on a discharge path that is formed when balancing of a battery cell is performed;
an RC circuit connected between the battery cell and the balancing circuit to measure a cell voltage of the battery cell;
an analog front end integrated circuit (AFE IC) configured to measure the cell voltage of the battery cell through the RC circuit after the balancing of the battery cell is completed; and
a micro controller unit (MCU) that is configured to receive the cell voltage measured by the AFE IC and configured to determine whether an abnormality has occurred in the RC circuit, and configured to transmit a control signal for controlling a switching time of the balancing switch to the AFE IC when it is determined that the abnormality has occurred in the RC circuit,
wherein the AFE IC is configured to control the switching time of the balancing switch based on the control signal received from the MCU to compensate for a cell voltage measurement error caused by the abnormality in the RC circuit.
